# EUROPÄISCHE PATENTSCHRIFT

(11) **EP 1 233 455 B1**
(45) Veröffentlichungstag und Bekanntmachung des Hinweises auf die Patenterteilung: **22.06.2011**
(21) Anmeldenummer: 02002386.7
(22) Anmeldetag: 31.01.2002
(51) Int. Cl.: H01L 27/115, H01L 21/8247, G11C 16/04, H01L 21/28, H01L 29/788

(54) **Nichtflüchtige Halbleiterspeicherzelle sowie Herstellungsverfahren und Programmierung**
Non-volatile semiconductor memory cell, method of fabrication and programming
Cellule de mémoire non-volatile, procédé de fabrication et programmation

(30) Priorität: 14.02.2001 DE 10106804
(43) Veröffentlichungstag der Anmeldung: 21.08.2002
(73) Patentinhaber: Infineon Technologies AG, 85579 Neubiberg (DE)
(72) Erfinder: Bradl, Stephan, Dr., 93096 Regensburg (DE); Heitzsch, Olaf, Dr., 01640 Coswig (DE)
(74) Vertreter: Kindermann, Peter

(56) Entgegenhaltungen:
- EP-A- 0 443 515
- DE-A1- 19 611 438
- US-A- 5 357 134
- US-A- 5 757 044
- US-A- 5 834 808
- US-A- 5 923 978

## Beschreibung

Die vorliegende Erfindung bezieht sich auf eine informationsredundante nichtflüchtige Halbleiterspeicherzelle sowie ein Verfahren zu deren Herstellung und Programmierung und insbesondere auf eine nichtflüchtige Halbleiterspeicherzelle mit zwei Speicherelementen.

Wiederbeschreibbare nichtflüchtige Halbleiterspeicherzellen gewinnen in hochintegrierten Schaltungen zunehmend an Bedeutung, da sie beispielsweise in Chipkarten veränderbare Daten über einen lange Zeitraum und ohne Verwendung einer Spannungsversorgung speichern können.

Je nach Art der verwendeten nichtflüchtigen Halbleiterspeicherzellen unterscheidet man grundsätzlich zwischen EEPROMs, EPROMs und FLASH-EPROM-Speicherzellen.

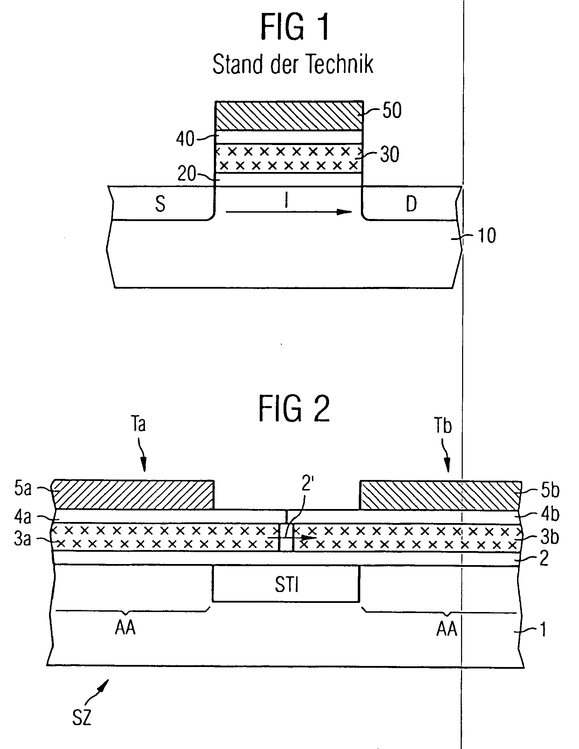

Figur 1 zeigt eine herkömmliche FLASH-Eintransistorzelle, wonach in einem aktiven Bereich eines Halbleitersubstrats 10 Source- und Draingebiete (S/D) zum Festlegen eines Kanalbereichs ausgebildet sind. Oberhalb des Kanalbereichs befindet sich eine Schichtenfolge aus einer Tunneloxidschicht 20, einer Floating-Gate-Schicht 30, einer dielektrischen Koppelschicht 40 und einer Steuerschicht 50, wodurch ein programmierbarer Feldeffekttransistor ausgebildet wird. Auf Grund der Verwendung der Floating-Gate-Schicht 30 bzw. ladungsspeichernden Schicht behalten derartige nichtflüchtige Speicherzellen nach Trennung von der Betriebsspannung ihre Information. Grundsätzlich unterscheidet man zwischen den drei Betriebsmodi: Löschen, Programmieren und Lesen.

Eine Information wird hierbei dadurch gespeichert, dass beispielsweise Elektronen durch die Tunneloxidschicht 20 tunneln und in der Floating-Gate-Schicht 30 permanent gespeichert werden. Als gelöschter Zustand wird hierbei ein Zustand bezeichnet, bei dem sich beispielsweise viele Elektronen in der Floating-Gate-Schicht 30 befinden. Dadurch wird die Einsatzspannung des Zelltransistors zu hohen Werten verschoben. Demgegenüber werden Speicherzellen als programmiert bezeichnet, wenn in der Floating-Gate-Schicht 30 beispielsweise ein Elektronenmangel herrscht und demzufolge die Einsatzspannung des Transistors erniedrigt ist.

Bei herkömmlichen Flash-Speicherzellen wird der gelöschte (hohe Einsatzspannung) bzw. programmierte (niedrige Einsatzspannung) Zustand dadurch überprüft, dass ein Strom I zwischen Source und Drain jeweils gegen eine feste Grenze bewertet wird. Genauer gesagt heißt das, dass für eine gelöschte Speicherzelle eine obere Stromgrenze Iₑᵣₐₛₑ existiert, wobei eine Speicherzelle nur dann als gelöscht betrachtet wird, wenn diese Zelle beim Lesen einen geringeren Strom liefert. Demgegenüber existiert für programmierte Speicherzellen eine untere Stromgrenze I_{prog}, wobei die Speicherzelle nur dann als programmiert betrachtet wird, wenn sie beim Lesen mehr Strom als dieser Grenzstrom liefert.

Zur Vermeidung von Fehlinterpretationen zwischen den programmierten und gelöschten Zuständen der jeweiligen Speicherzellen ist der Grenzstrom Iₑᵣₐₛₑ größer als der Grenzstrom I_{prog}, wobei eine Differenz zwischen diesen Grenzströmen um so kleiner sein kann, je empfindlicher eine Auswerteschaltung bzw. ein "sense amplifier" ist und je mehr Zeit zum Lesen zur Verfügung steht.

Ein grundsätzliches Wesensmerkmal von herkömmlichen nichtflüchtigen Halbleiterspeicherzellen ist jedoch, dass mit zunehmender Anzahl von Programmier-/Lösch-Zyklen sich die Einsatzspannungen des gelöschten und programmierten Zustandes einander annähern, da während des Lösch- und Programmiervorgangs "Löcher" teilweise in die Tunneloxidschicht 20 eingebaut werden. Die erreichten Verschiebungen der Einsatzspannung verringern sich immer mehr, weshalb die Einsatzspannung des gelöschten und des programmierten Zustandes mit zunehmender Zyklenanzahl, d.h. Anzahl von Programmier-/Lösch-Zyklen, zum UV-gelöschten Zustand konvergieren, der sich dadurch auszeichnet, dass in der Floating-Gate-Schicht 30 keine Ladung gespeichert ist.

Die Anzahl der Programmier-/Lösch-Zyklen bzw. eine sogenannte Endurance von herkömmlichen nichtflüchtigen Halbleiterspeicherzellen wird demzufolge dadurch begrenzt, dass entweder der gelöschte oder der programmierte Zustand nicht mehr die Bewertungskriterien für den Grenzstrom erfüllt.

Zur Verbesserung der Zyklenfestigkeit bzw. einer Endurance wurde daher eine Vielzahl von Möglichkeiten untersucht, wobei beispielsweise eine Qualität der Tunneloxidschicht, eine Zusammensetzung dieser Schicht oder das Ausbilden von getrennten Tunnelfenstern in Betracht gezogen wurde. Ferner wurden zur Verringerung von Oxidschädigungen Implantationsparameter und Plasmaparameter optimiert. In gleicher Hinsicht wurden Designoptimierungen und Optimierungen der elektrischen Bedingungen zum Löschen bzw. Programmieren durchgeführt.

Aus der Druckschrift DE 196 11 438 A1 ist eine Multibit-Halbleiterspeicherzelle bekannt, die entlang eines Kanals zwei voneinander getrennte und nebeneinanderliegende Speicherschichten aufweist. Die Speicherschichten sind hierbei durch einen Spacer und eine Tunnelschicht voneinander getrennt. Dies ermöglicht durch Varriieren der wirksamen Kanallänge drei verschiedene Ausgabeniveaus, in Abhängigkeit davon, ob eine oder beide der Speicherschichten programmiert oder gelöscht sind.

Die Druckschrift US-A-5 757 044 offenbart eine weitere herkömmliche Halbleiterspeicherzelle, wobei zur Vermeidung eines "over-erase"-Effektes eine Vielzahl von ladungsspeichernden Schichten entlang eines Kanals des Speicherelements angeordnet und voneinander isoliert ist.

Aus der Druckschrift EP-A-0 443 515 ist eine herkömmliche nichtflüchtige Flash-Speicheranordnung bekannt, wobei eine Vielzahl von nichtflüchtigen Halbleiterspeicherzellen matrixförmig angeordnet ist. Zur Verbesserung der Löscheigenschaften bei gleichzeitig verbesserten elektrischen Eigenschaften des Gateoxids wird eine Löschelektrode seitlich über ein Tunneloxid an die ladungsspeichernde Schicht angeflanscht.

Der Erfindung liegt demgegenüber die Aufgabe zu Grunde, eine informationsredundante nichtflüchtige Halbleiterspeicherzelle, sowie Verfahren zu deren Herstellung und Programmierung zu schaffen, die eine erhöhte Datensicherheit sowie eine verbesserte Endurance bzw. Zyklenfestigkeit aufweist.

Erfindungsgemäß wird diese Aufgebe hinsichtlich der Halbleiterspeicherzelle durch die Merkmale des Patentanspruchs 1, hinsichtlich des Herstellungsverfahrens durch die Maßnahmen des Patentanspruchs 11 und hinsichtlich des Programmierverfahrens durch die Maßnahmen der Patentansprüche 17 bis 20 gelöst.

Insbesondere durch die Verwendung eines ersten und zweiten nichtflüchtigen Speicherelements mit jeweiligen Source-/Draingebieten sowie mit einer jeweiligen ladungsspeichernden Schicht, wobei die ladungsspeichernden Schichten über eine Tunnel-Isolierschicht derart miteinander gekoppelt werden, dass ein Ladungsaustausch zwischen den Speicherelementen ermöglicht ist, erhält man insbesondere bei einer relativen Auswertung der Kanalströme der Speicherelemente zueinander eine wesentlich höhere Programmier-/Lösch-Zyklenzahl. Bei absoluter Auswertung kann darüber hinaus eine erhöhte Datensicherheit realisiert werden, da die gespeicherte Information jeweils redundant in den beiden nichtflüchtigen Speicherelementen vorliegt und bei Ausfall eines Speicherelements immer noch die Information des anderen Speicherelements zur Auswertung zur Verfügung steht.

Die Tunnel-Isolierschicht weist vorzugsweise ein Tunneloxid auf und ist entweder senkrecht und/oder parallel zur Substratoberfläche angeordnet.

Als eine erste Isolierschicht wird vorzugsweise eine OTP-Schicht zum einmaligen Programmieren der nichtflüchtigen Speicherelemente verwendet, wodurch ein Einbringen von Ladungsträgern bzw. ein Vorladen beispielsweise durch eine elektrische Ansteuerung oder aber auch prozesstechnisch beispielsweise durch Einstellung einer jeweiligen Plasmadichte im Ätzprozess durchgeführt werden kann.

Als ladungsspeichernde Schichten werden vorzugsweise elektrisch leitende Halbleiterschichten und insbesondere hochdotierte amorphe Halbleiterschichten verwendet, wodurch sich eine besonders einfache Herstellung dieser Schichten sowie der Tunnel-Isolierschicht ergibt.

Eine zweite Isolierschicht besteht vorzugsweise aus einer ONO-Schichtenfolge, wodurch die Herstellung stark vereinfacht wird und sich die Kosten reduzieren.

Gemäß einem bevorzugten Verfahren zum Vorladen der informationsredundanten nichtflüchtigen Halbleiterspeicherzelle wird zunächst ein Anlegen einer ersten positiven Vorladespannung an die Steuerschichten der nichtflüchtigen Halbleiterspeicherzelle und anschließend ein Anlegen einer zweiten Vorladespannung, die kleiner als die erste Vorladespannung ist, an die Source-/Draingebiete der Speicherelemente derart angelegt, dass Ladungsträger mittels Fowler-Nordheim-Tunneln in die ladungsspeichernden Schichten eingebracht werden.

Ferner kann ein Vorladen auch durch Anlegen einer ersten positiven Vorladespannung an die Steuerschichten der nichtflüchtigen Halbleiterspeicherzelle, ein Anlegen einer zweiten Vorladespannung, die kleiner als die erste Vorladespannung ist, an die Sourcegebiete und durch ein Anlegen einer dritten Vorladespannung, die kleiner als die erste Vorladespannung aber größer als die zweite Vorladespannung ist, an die Draingebiete der Speicherelemente derart erfolgen, dass Ladungsträger mittels Kanalinjektion bzw. Injektion heißer Elektronen in die ladungsspeichernden Schichten eingebracht werden.

Zum Beschreiben/Löschen der informationsredundanten nichtflüchtigen Halbleiterspeicherzelle wird vorzugsweise eine erste positive Schreibspannung an die Steuerschicht des ersten Speicherelements, eine zweite negative Schreibspannung an die Steuerschicht des zweiten Speicherelements, eine dritte Schreibspannung, die kleiner als die erste Schreibspannung ist, an die Source-/Draingebiete des ersten Speicherelements und eine vierte Schreibspannung, die kleiner als die dritte Schreibspannung, aber größer als die zweite Schreibspannung ist, an die Source-/Draingebiete des zweiten Speicherelements angelegt. Auf diese Weise können über die zwischen den ladungsspeichernden Schichten existierende Tunnel-Isolierschicht Ladungsträger zwischen den beiden Speicherelementen hin und her geschoben werden, weshalb eine absolute Anzahl von gespeicherten Ladungsträgern unbedeutend ist.

Zum Lesen der nichtflüchtigen Halbleiterspeicherzelle wird vorzugsweise eine erste negative Lesespannung an die Steuerschichten der Speicherelemente zum Auswählen einer Halbleiterspeicherzelle, ferner eine zweite Lesespannung, die größer als die erste Lesespannung ist, an die Sourcegebiete des ers ten und zweiten Speicherelements, eine dritte Lesespannung, die größer als die zweite Lesespannung ist, an die Draingebiete der ersten und zweiten Speicherelemente angelegt und anschließend die Kanalströme der ersten und zweiten Speicherelemente verglichen. Demzufolge kann auch bei einem hohen Ladungsverlust beispielsweise auf Grund von Leckströmen oder einer starken Verschiebung der Einsatzspannung auf Grund von Löchern in der Tunneloxidschicht ein Informationszustand der Halbleiterspeicherzelle sehr lange eindeutig ausgewertet werden.

In den weiteren Ansprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: eine vereinfachte Schnittansicht einer nichtflüch- tigen Halbleiterspeicherzelle gemäß dem Stand der Technik;
- Figur 2: eine vereinfachte Schnittansicht einer informati- onsredundanten nichtflüchtigen Halbleiterspeicher- zelle gemäß einem ersten Ausführungsbeispiel;
- Figur 3: eine vereinfachte Schnittansicht einer informati- onsredundanten nichtflüchtigen Halbleiterspeicher- zelle gemäß einem zweiten Ausführungsbeispiel;
- Figur 4: eine vereinfachte Schnittansicht einer informationsredundanten nichtflüchtigen Halbleiterspeicherzelle gemäß einem dritten Ausführungsbeispiel;
- Figur 5: eine vereinfachte Draufsicht einer informationsredundanten nichtflüchtigen Halbleiterspeicherzelle gemäß einem vierten Ausführungsbeispiel;
- Figur 6: eine vereinfachte Schnittansicht der Halbleiterspeicherzelle gemäß Figur 5 entlang eines Schnitts I-I';
- Figur 7: ein elektrisches Ersatzschaltbild der erfindungsgemäßen informationsredundanten nichtflüchtigen Halbleiterspeicherzelle; und
- Figur 8: eine vereinfachte Blockdarstellung einer matrixförmig angeordneten Speichervorrichtung mit erfindungsgemäßen informationsredundanten nichtflüchtigen Halbleiterspeicherzellen.

Figur 2 zeigt eine vereinfachte Schnittansicht einer informationsredundanten nichtflüchtigen Halbleiterspeicherzelle gemäß einem ersten Ausführungsbeispiel, wobei in einem Halbleitersubstrat 1 wie z.B. einem Silizium-Halbleitersubstrat aktive Bereiche AA beispielsweise durch flache Grabenisolierung STI (shallow trench isolation) ausgebildet werden. In den aktiven Bereichen AA sind ferner nicht dargestellte Source- und Draingebiete zur Realisierung eines Feldeffekttransistors beispielsweise durch Implantation oder sonstiger Dotierung ausgebildet. Die informationsredundante nichtflüchtige Halbleiterspeicherzelle besteht im Wesentlichen aus einem ersten nichtflüchtigen Speicherelement Ta und einem zweiten nichtflüchtigen Speicherelement Tb, die beispielsweise den Aufbau der FLASH-Eintransistor-Speicherzelle gemäß Figur 1 aufweisen können. Sie sind jedoch nicht darauf beschränkt und können auch andere Speicherelemente mit beispielsweise separatem Tunnelfenster und dergleichen aufweisen.

Das erste nichtflüchtige Speicherelement Ta besteht demzufolge aus einer Schichtenfolge einer ersten Isolierschicht 2, einer ladungsspeichernden Schicht 3a, einer zweiten Isolierschicht 4a und einer Steuerschicht 5a, die oberhalb eines im aktiven Bereich AA ausgebildeten Kanalbereichs liegen. In gleicher Weise besteht das zweite nichtflüchtige Speicherelement Tb aus einer ersten Isolierschicht 2, einer ladungsspeichernden Schicht 3b, einer zweiten Isolierschicht 4b und einer Steuerschicht 5b. Als besonderes Merkmal der informationsredundanten nichtflüchtigen Halbleiterspeicherzelle befindet sich eine Tunnel-Isolierschicht 2' zwischen den ladungsspeichernden Schichten 3a und 3b der jeweiligen Speicherelemente Ta und Tb derart, dass ein Ladungsaustausch zwischen den Speicherelementen über diese Tunnel-Isolierschicht 2' ermöglicht ist.

Die prinzipielle Funktionsweise dieser Halbleiterspeicherzelle benötigt hierbei einen Vorladeprozess, bei dem zunächst eine bestimmte Ladungsträgeranzahl in einer oder beiden ladungsspeichernden Schichten 3a und 3b über die erste Isolierschicht 2 eingebracht wird. Dieses definierte Vorladen der ladungsspeichernden Schichten 3a und 3b kann beispielsweise über eine elektrische Ansteuerung der jeweiligen Source- und Draingebiete sowie den Steuerschichten der Speicherelemente erfolgen. Sie kann jedoch auch bereits während eines Herstellungsverfahrens prozesstechnisch realisiert werden, wobei beispielsweise eine Plasmadichte in einem Ätzverfahren variiert wird und somit eine Aufladung bzw. eine Ladungsträgeranzahl in der ladungsspeichernden Schicht 3a und 3b eingestellt werden kann.

Nach diesem in der Regel einmalig stattfindenden Vorladeprozess erfolgt ein Programmieren/Löschen der Halbleiterspeicherzelle lediglich durch gezieltes Verschieben der Ladungen über die Tunnel-Isolierschicht 2' in die eine oder andere ladungsspeichernde Schicht 3a oder 3b. Die resultierenden Kanalströme zwischen den jeweiligen Source- und Draingebieten der Speicherelemente Ta und Tb werden anschließend miteinander verglichen und ergeben einen jeweiligen Informationsgehalt der informationsredundanten nichtflüchtigen Halbleiterspeicherzelle. Auf Grund des relativen Vergleichs der Kanalströme in den Speicherelementen untereinander reicht daher ein minimaler Ladungsunterschied zwischen den Speicherelementen aus, um einen Informationsgehalt exakt zu definieren. Eine Endurance bzw. Anzahl von Programmier/Lösch-Zyklen kann somit wesentlich erhöht werden, da einerseits eine Qualität der ersten Isolierschicht durch die Programmier/Löschvorgänge nicht negativ beeinflusst wird und ferner lediglich eine Ladungsverschiebung über die Tunnel-Isolierschicht zwischen den ladungsspeichernden Schichten 3a und 3b stattfindet.

Darüber hinaus bietet jedoch eine derartige informationsredundante nichtflüchtige Halbleiterspeicherzelle einen weiteren Vorteil dahingehend, dass sie eine besonders hohe Datensicherheit ermöglicht. Genauer gesagt kann unter Verwendung des gleichen Halbleiterspeicherzellentyps und unter Verwendung einer alternativen Auswerteschaltung die Datensicherheit, wie sie insbesondere in Chipkarten sowie im Automotiveund Avionic-Bereich gefordert ist, realisiert werden. In diesem Falle werden die in den jeweiligen Speicherelementen Ta und Tb gespeicherten Informationseinheiten, die zueinander symmetrisch sind, nicht miteinander verglichen, sondern wie beim Stand der Technik gegenüber einem festen Bezugswert bewertet. Falls nunmehr eines der Speicherelemente Ta oder Tb auf Grund von Schädigungen z.B. in den Isolierschichten oder leitenden Schichten ausfällt, kann der Informationsgehalt der Speicherzelle weiterhin über das redundante Speicherelement ermittelt werden. Auf Grund des doppelten Einsatzgebietes einer derartigen informationsredundanten Halbleiterspeicherzelle verringern sich demzufolge auf Grund des höheren Marktvolumens die Herstellungskosten erheblich.

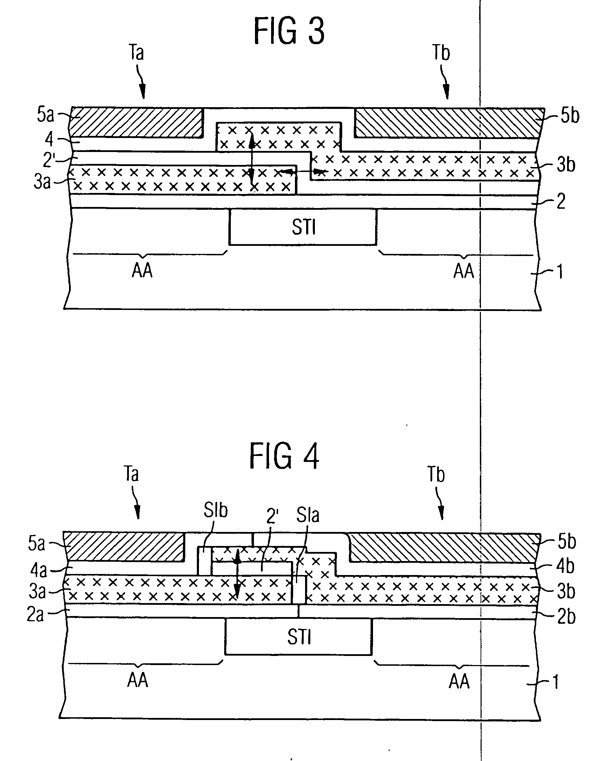

Figur 3 zeigt eine vereinfachte Schnittansicht einer informationsredundanten nichtflüchtigen Halbleiterspeicherzelle gemäß einem zweiten Ausführungsbeispiel, wobei gleiche Bezugszeichen gleiche oder ähnliche Schichten bezeichnen und auf eine wiederholte Beschreibung nachfolgend verzichtet wird.

Gemäß Figur 3 besteht das erste und zweite Speicherelement Ta und Tb wiederum aus einer Schichtenfolge einer ersten Isolierschicht 2, einer ladungsspeichernden Schicht 3a und 3b, einer zweiten Isolierschicht 4 und einer Steuerschicht 5a und 5b. Zur Vereinfachung eines Herstellungsprozesses wird gemäß Figur 3 jedoch die Tunnel-Isolierschicht nach Ausbilden der ladungsspeichernden Schicht des ersten Speicherelements Ta ganzflächig ausgebildet und anschließend die ladungsspeichernde Schicht 3b des zweiten Speicherelements Tb überlappend darüber angeordnet. Auf diese Weise ergeben sich sowohl im Wesentlichen senkrecht als auch parallel zur Substratoberfläche liegende Tunnel-Isolierschichtbereiche, die ein vereinfachtes Ladungsverschieben zwischen den ladungsspeichernden Schichten 3a und 3b ermöglicht. Gemäß Figur 3 besteht die zweite Isolierschicht 4 aus einer einzigen ganzflächig ausgebildeten dielektrischen Koppelschicht. Sie kann jedoch wie in Figur 2 auch aus jeweils getrennten Schichten bestehen.

Figur 4 zeigt eine vereinfachte Schnittansicht einer informationsredundanten nichtflüchtigen Halbleiterspeicherzelle gemäß einem dritten Ausführungsbeispiel, wobei gleiche Bezugszeichen gleiche oder ähnliche Schichten wie in Figuren 2 und 3 bezeichnen und auf eine wiederholte Beschreibung nachfolgend verzichtet wird.

Gemäß Figur 4 kann die Tunnel-Isolierschicht 2' auch nur in einem im Wesentlichen parallel zur Substratoberfläche verlaufenden Bereich zwischen der ersten und zweiten ladungsspeichernden Schicht 3a und 3b ausgebildet werden, wobei in diesem Fall nach einer Ausbildung und Strukturierung der ladungsspeichernden Schicht 3a des ersten Speicherelements Ta eine Seitenwandisolation Sia ausgebildet wird. Anschließend erfolgt ein Ausbilden der Tunnel-Isolierschicht 2' an der Oberfläche der ladungsspeichernden Schicht 3a mit einer nachfolgenden Strukturierung. Abschließend wird die ladungsspeichernde Schicht 3b zum Teil überlappend über der Tunnel-Isolierschicht 2' bzw. der ladungsspeichernden Schicht 3a ausgebildet und strukturiert bzw. ebenfalls mit einer Seitenwandisolation Sib versehen. Auf diese Weise erhält man eine Halbleiterspeicherzelle mit verbesserten LeckeLgenschaften.

Gemäß Figur 4 kann nicht nur die zweite Isolierschicht aus einer jeweiligen Isolierschicht 4a und 4b für das erste und zweite Speicherelement Ta und Tb bestehen, sondern es können auch für die erste Isolierschicht unterschiedliche erste Isolierschichten 2a und 2b für die jeweiligen Speicherelemente verwendet werden. Insbesondere kann auf diese Weise lediglich auf einer Seite bzw. für ein Speicherelement ein besonders hochwertiges Tunneloxid für das einmalige Programmieren bzw. Vorladen der Halbleiterspeicherzelle verwendet werden.

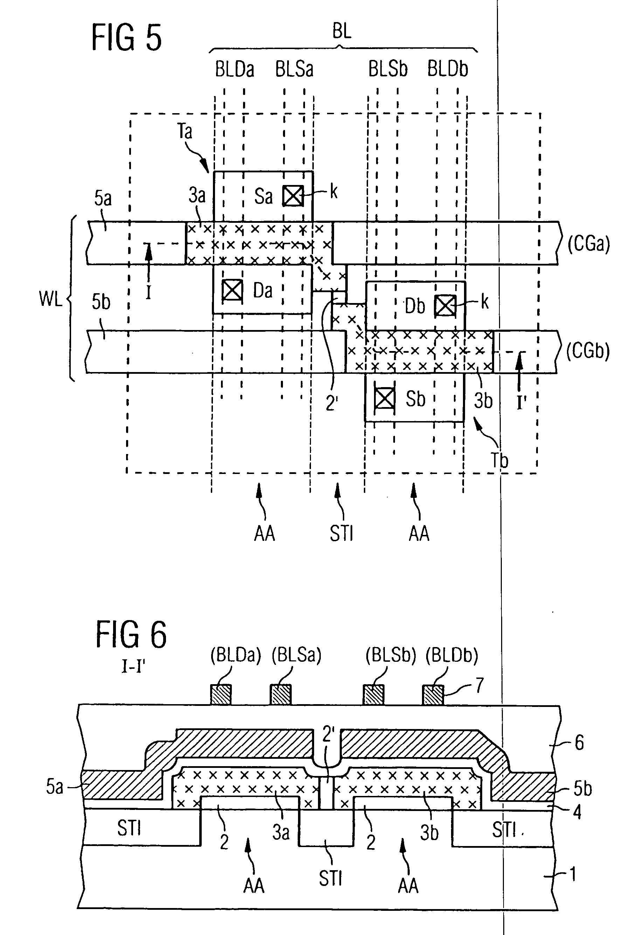

Nachfolgend wird ein Verfahren zur Herstellung einer informationsredundanten nichtflüchtigen Halbleiterspeicherzelle gemäß einem vierten Ausführungsbeispiel anhand der Figuren 5 und 6 im Einzelnen beschrieben.

Figur 5 zeigt hierbei eine vereinfachte Draufsicht einer informationsredundanten nichtflüchtigen Halbleiterspeicherzelle gemäß dem vierten Ausführungsbeispiel und Figur 6 eine vereinfachte Schnittansicht dieser Halbleiterspeicherzelle entlang eines Schnitts I-I'. Gleiche Bezugszeichen bezeichnen hierbei wiederum gleiche oder ähnliche Schichten bzw. Elemente, weshalb auf eine wiederholte Beschreibung nachfolgend verzichtet wird.

Gemäß Figur 6 werden zunächst in einem Halbleitersubstrat 1 aktive Bereiche AA vorzugsweise mittels flacher Grabenisolierung STI (shallow trench Isolation) ausgebildet. Die aktiven Bereiche AA können jedoch auch mit anderen Isolationsverfahren im Halbleitersubstrat 1 ausgebildet werden. Anschließend wird eine erste Isolierschicht 2 ganzflächig ausgebildet, wobei vorzugsweise eine OTP-Schicht zum einmaligen Programmieren der nichtflüchtigen Speicherelemente verwendet wird. Diese OTP-Schicht besteht beispielsweise aus einem thermisch ausgebildeten Siliziumdioxid, weshalb sie lediglich oberhalb der aktiven Bereiche AA eine relevante Dicke annimmt. Alternativ können jedoch auch andere Isolierschichten und insbesondere hochwertige Gateoxide als erste Isolierschichten ausgebildet werden.

Nachfolgend wird eine ladungsspeichernde Schicht 3a ganzflächig ausgebildet und derart strukturiert, dass sie eine ladungsspeichernde Schicht 3a für ein erstes Speicherelement Ta darstellt. Vorzugsweise wird für diese ladungsspeichernde Schicht eine elektrisch leitende amorphe Siliziumschicht abgeschieden. Es kann jedoch in gleicher Weise insitu-dotiertes Polysilizium abgeschieden werden und mittels eines herkömmlichen Ätzprozesses strukturiert werden. Bei Verwendung von Plasmaätzverfahren kann ein vorstehend beschriebenes Vorladen der Halbleiterspeicherzelle durch Einstellen einer jeweiligen Plasmadichte erfolgen. In einem nachfolgenden Prozessschritt wird eine Tunnel-Isolierschicht 2' vorzugsweise thermisch ausgebildet, wobei ein herkömmlicher Ofenprozess oder ein RTP-Prozess (rapid thermal process) verwendet wird. Gemäß Figur 6 wird die so ausgebildete Tunnel-Isolierschicht 2', welche beispielsweise ein thermisch ausgebildetes Tunneloxid darstellt, im Wesentlichen senkrecht zur Substratoberfläche zurückgebildet, wobei jedoch auch die in den Figuren 2 bis 4 möglichen grundsätzlichen Anordnungen denkbar sind.

Anschließend wird eine weitere ladungsspeichernde Schicht zur Realisierung der ladungsspeichernden Schicht 3b ausgebildet und strukturiert, wobei wiederum beispielsweise elektrisch leitendes amorphes Halbleitermaterial (Si) oder insitu-dotiertes Polysilizium abgeschieden wird.

Anschließend kann beispielsweise mittels eines chemischmechanischen Polierverfahrens (CMP, chemical mechanical polishing) eine ebene Struktur für die ladungsspeichernden Schichten 3a und 3b realisiert werden. In gleicher Weise kann jedoch auch eine selektiv zur Tunnel-Isolierschicht 2` durchgeführte Plasma- oder Nassätzung durchgeführt werden, wodurch sich überlappende ladungsspeichernde Schichten realisieren lassen.

In einem nachfolgenden Prozessschritt wird eine zweite Isolierschicht 4 ganzflächig ausgebildet, wobei beispielsweise eine ONO-Schichtenfolge (Oxid/Nitrid/Oxid) als Koppeldielektrikum ausgebildet wird. In gleicher Weise können jedoch auch dielektrische Schichten mit hoher relativer Dielektrizitätskonstante verwendet werden, wie z.B. TiN, ..., wodurch ein Koppelfaktor zur Reduzierung der Programmierspannungen verbessert werden kann.

In einem nachfolgenden Verfahrensschritt wird eine elektrisch leitende Schicht ausgebildet und strukturiert, wobei die jeweiligen Steuerschichten 5a und 5b bzw. die Wortleitungen WLa und WLb des ersten und zweiten Speicherelements Ta und Tb realisiert werden. Als Material für die elektrisch leitenden Steuerschichten kann beispielsweise hochdotiertes Halbleitermaterial und/oder metallisches Material verwendet werden. Vorzugsweise wird wiederum hochdotiertes Polysilizium, Tungsten-Silizid oder ein Metall für die Steuerschichten 5a und 5b verwendet.

Anschließend erfolgt eine weitere Strukturierung der ersten und zweiten Isolierschicht 2 und 4 sowie der ersten und zweiten ladungsspeichernden Schicht 3a und 3b zum Ausbilden von isolierten ladungsspeichernden Inseln, die sich nur noch über die Tunnel-Isolierschicht 2' berühren. Vorzugsweise werden in einem nachfolgenden Schritt Source-/Draingebiete S/D im aktiven Bereich AA für die jeweiligen Speicherelemente Ta und Tb unter Verwendung der strukturierten Steuerschicht 5a und 5b, der zweiten Isolierschicht 4, der ladungsspeichernden Schicht 3a und 3b sowie der ersten Isolierschicht 2 als Maske mittels Ionenimplantation selbstjustierend ausgebildet. Darüber hinaus kann auch ein sogenanntes LDD-Gebiet sowie Spacer an den jeweiligen Wortleitungsstapeln ausgebildet werden.

Zur Realisierung einer dritten Isolierschicht 6 wird beispielsweise BPSG (Bor-Phosphor-Silikatglas), PSG (Phosphor-Silikatglas) oder APUSG (atmoshperic pressure undoped silicon glass) mittels beispielsweise HDP-, PE, oder LP-chemischem Abscheideverfahren ausgebildet. In dieser dritten Isolierschicht werden anschließend Kontaktlöcher zu den jeweiligen Sourcegebieten Sa, Sb und Draingebieten Da, Db der Speicherelemente Ta und Tb freigeätzt und zum Ausbilden von Kontakten K beispielsweise mit W, Poly, Alu, Kupfer usw. aufgefüllt.

Abschließend wird eine Bitleitungsschicht 7 ausgebildet und zur Realisierung von Bitleitungen BLDa, BLSa, BLSb und BLDb für das erste und zweite Speicherelement Ta und Tb strukturiert. Die Bitleitungen liegen hierbei im Wesentlichen oberhalb der aktiven Bereiche AA und kreuzen die Wortleitungen WL zur Realisierung einer matrixförmigen Speichervorrichtung.

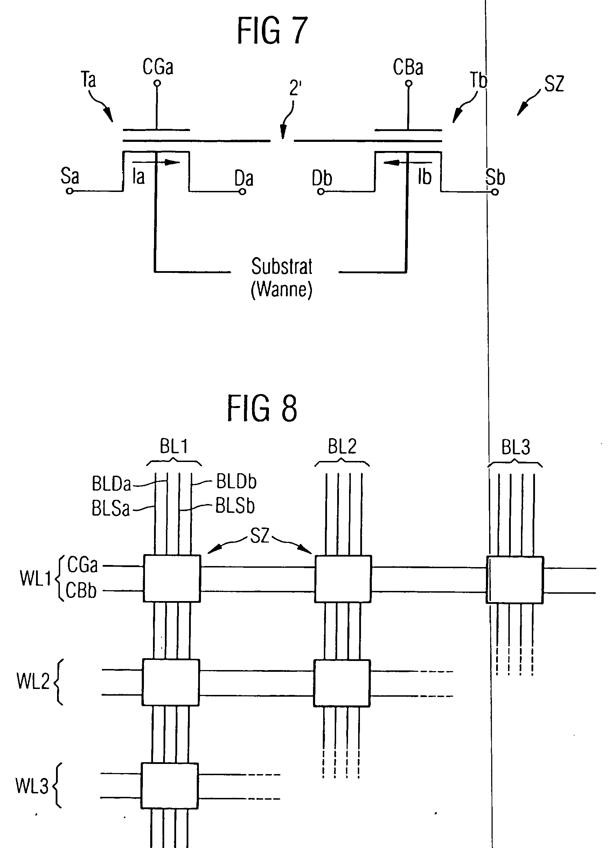

Figur 7 zeigt ein elektrisches Ersatzschaltbild der erfindungsgemäßen informationsredundanten nichtflüchtigen Halbleiterspeicherzelle SZ wobei gleiche Bezugszeichen wiederum gleiche oder ähnliche Elemente bezeichnen und auf eine wiederholte Beschreibung nachfolgend verzichtet wird.

Gemäß Figur 7 besteht die nichtflüchtige Halbleiterspeicherzelle SZ aus zwei nichtflüchtigen Speicherelementen Ta und Tb, deren ladungsspeichernde Schichten über die Tunnel-Isolierschicht 2' miteinander gekoppelt sind. Jeweilige Kanalströme Ia und Ib können zur Verbesserung einer Endurance miteinander verglichen werden. Alternativ kann jedoch auch zur Verbesserung einer Datensicherheit ein jeweiliger Kanalstrom Ia und Ib der Speicherelemente Ta und Tb jeweils gegenüber einem festen Bezugswert bewertet werden, wobei auch bei Verlust von Informationen in einem Speicherelement die Information der Halbleiterspeicherzelle über das andere Speicherelement zuverlässig ermittelt werden kann. Insbesondere die bei Chipkarten sowie im Automobil- und Flugzeugbau geforderten hohen Anforderungen bezüglich Datensicherheit können mit diesem Halbleiterspeicherzellen-Typ zuverlässig erfüllt werden.

Figur 8 zeigt ein vereinfachtes Blockschaltbild einer Matrixanordnung der vorstehend beschriebenen nichtflüchtigen Halbleiterspeicherzellen, wobei gleiche Bezugszeichen wiederum gleiche oder ähnliche Elemente bezeichnen und auf eine wiederholte Beschreibung nachfolgend verzichtet wird.

Gemäß Figur 8 werden die informationsredundanten nichtflüchtigen Halbleiterspeicherzellen SZ beispielsweise matrixförmig angeordnet und über Wortleitungen WL1 bis WL3 und Bitleitungen BL1 bis BL3 zeilen- bzw. spaltenweise angesteuert. Die Bitleitungen bestehen hierbei aus jeweils vier Teil-Bitleitungen BLSa, BLDa, BLSb und BLDb zum Ansteuern der jeweiligen Source- und Draingebiete. In gleicher Weise bestehen die Wortleitungen aus Teil-Wortleitungen CGa und CGb zum Ansteuern der jeweiligen Steuerschichten 5a und 5b der nichtflüchtigen Speicherelemente Ta und Tb.

Nachfolgend wird ein Verfahren zur Programmierung der vorstehend beschriebenen informationsredundanten nichtflüchtigen Halbleiterspeicherzelle beschrieben.

Zur Realisierung einer Vorladung bzw. Initialisierung der informationsredundanten nichtflüchtigen Halbleiterspeicherzelle wird zunächst eine vorbestimmte Anzahl von Ladungsträgern auf dem gemeinsamen Floating Gate bzw. der gemeinsamen ladungsspeichernden Schichten abgelegt. Genauer gesagt soll die Summe der Anzahl der Ladungsträger auf der ladungsspeichernden Schicht 3a und der ladungsspeichernden Schicht 3b des ersten und zweiten Speicherelements für alle Halbleiterspeicherzellen SZ konstant sein. Für diese Initialisierung bieten sich neben der prozesstechnischen Vorladung (mittels Plasma) im Wesentlichen zwei Verfahren zum elektrischen Ansteuern der Halbleiterspeicherzellen an.

Beispielsweise wird zur Realisierung eines Fowler-Nordheim-Tunnels durch die erste Isolierschicht 2 eine Spannung von +20 V an die Steuerschichten 5a und 5b bzw. die Teil-Wortleitungen CGa und CGb angelegt. Die Teil-Bitleitungen BLSa, BLDa, BLSb und BLDb bzw. die dazugehörigen Source- und Draingebiete Sa, Da, Sb, Db besitzen hierbei ein Potential von 0 V.

Alternativ kann ein derartiges Vorladen bzw. Einbringen einer vorbestimmten Anzahl von Ladungsträgern in die ladungsspeichernden Schichten auch mittels Injektion von heißen Kanalelektronen über die erste Isolierschicht 2 erfolgen. Hierbei wird die Teil-Wortleitung CGa und CGb bzw. die dazugehörigen Steuerschichten 5a und 5b auf +12 V gelegt, während die Spannungen der Sourcegebiete Sa und Sb 0 V betragen und die Spannungen der dazugehörigen Draingebiete Da und Db 7 V aufweisen.

Mit beiden Verfahren kann die ladungsspeichernde Schicht 3a und 3b jeweils gleich mit Ladungsträgern bzw. Elektronen beladen werden.

Zum Beschreiben bzw. Löschen der informationsredundanten nichtflüchtigen Halbleiterspeicherzelle werden vorzugsweise zum Einschreiben eines Bits "1" bzw. "high" die Teil-Wortleitung CGa auf ein Potential von 20 V, die Drain- und Sourcegebiete Da und Sa des ersten Speicherelements Ta auf ein Potential von +7 V und die Teil-Wortleitung CGb auf ein Potential von -20 V gelegt, während die Source- und Draingebiete Db und Sb des zweiten Speicherelements Tb eine Spannung von 0 V aufweisen und eine Wanne bzw. das Halbleitersubstrat 1 ebenfalls eine Spannung von 0 V aufweist. Zur Realisierung eines Informationsgehaltes "0" bzw. "low" werden die Potentiale an den Speicherelementen Ta und Tb entsprechend vertauscht. Es sei darauf hingewiesen, dass in diesem Zusammenhang ein Beschreiben sowohl ein Programmieren als auch ein Löschen in Abhängigkeit von einer jeweiligen Definition bedeuten kann.

Zum Auslesen der informationsredundanten nicht flüchtigen Halbleiterspeicherzellen werden vorzugsweise alle Teil-Wortleitungen CGa und CGb von ausgewählten bzw. selektierten Halbleiterspeicherzellen auf ein Potential von 0 V bis -5 V gelegt, wodurch alle Kanäle aufgemacht bzw. durchgeschaltet werden. Für nicht selektierte bzw. nicht ausgewählte Halbleiterspeicherzellen werden die dazugehörigen Teil-Wortleitungen CGa und CGb auf ein Potential von beispielsweise +5 V gelegt, wodurch alle Kanäle in diesen Halbleiterspeicherzellen bzw. Speicherelementen geschlossen werden und somit kein Störsignal bilden. Die Sourcegebiete der Speicherelemente Ta und Tb werden anschließend auf 0 V und die Draingebiete Da und Db der Speicherelemente werden auf 2,5 V gelegt. Anschließend werden die Kanalströme Ia und Ib des ersten und zweiten Speicherelements miteinander verglichen, wobei der Informationsgehalt der Halbleiterspeicherzelle "1" bzw. "high" ist, wenn Ia > Ib ist. Anderenfalls ergibt sich als Informationsgehalt das Bit "0" bzw. "low".

Die Erfindung wurde vorstehend anhand von Eintransistor-FLASH-Zellen als Speicherelemente beschrieben. Sie ist jedoch nicht darauf beschränkt und umfasst in gleicher Weise auch andere nichtflüchtige Speicherelemente, deren ladungsspeichernde Schichten über eine Tunnel-Isolierschicht miteinander gekoppelt sind.

## Patentansprüche

1. Informationsredundante nichtflüchtige Halbleiterspeicherzelle mit
einem ersten und einem zweiten nichtflüchtigen Speicherelement (Ta, Tb), welche jeweils eine Schichtenfolge aus einer ersten Isolierschicht (2), einer ladungsspeichernden Schicht (3a, 3b), einer zweiten Isolierschicht (4a, 4b) und einer Steuerschicht (5a, 5b) auf einem jeweiligen aktiven Bereich (AA) eines Halbleitersubstrats (1) und jeweils Source-/Draingebiete (S/D) aufweisen, wobei die ladungsspeichernden Schichten (3a, 3b) über eine Tunnel-Isolierschicht (2') derart miteinander gekoppelt werden, dass ein Ladungsaustausch zwischen den Speicherelementen (Ta, Tb) ermöglicht ist.

2. Informationsredundante nichtflüchtige Halbleiterspeicherzelle nach Patentanspruch 1,
**dadurch gekennzeichnet, dass** die Tunnel-Isolierschicht (2') ein Tunneloxid aufweist.

3. Informationsredundante nichtflüchtige Halbleiterspeicherzelle nach Patentanspruch 1 oder 2,
**dadurch gekennzeichnet, dass** die Tunnel-Isolierschicht (2') im Wesentlichen senkrecht zur Substratoberfläche zwischen den ladungsspeichernden Schichten (3a, 3b) ausgebildet ist.

4. Informationsredundante nichtflüchtige Halbleiterspeicherzelle nach einem der Patentansprüche 1 bis 3,
**dadurch gekennzeichnet, dass** die Tunnel-Isolierschicht (2') im Wesentlichen parallel zur Substratoberfläche zwischen den ladungsspeichernden Schichten (3a, 3b) ausgebildet ist.

5. Informationsredundante nichtflüchtige Halbleiterspeicherzelle nach einem der Patentansprüche 1 bis 4,
**dadurch gekennzeichnet, dass** die erste Isolierschicht (2) eine OTP-Schicht zum einmaligen Programmieren der nichtflüchtigen Speicherelemente (Ta, Tb) aufweist.

6. Informationsredundante nichtflüchtige Halbleiterspeicherzelle nach einem der Patentansprüche 1 bis 5,
**dadurch gekennzeichnet, dass** die ladungsspeichernde Schicht (3a) des ersten Speicherelements (Ta) eine erste elektrisch leitende Halbleiterschicht und die ladungsspeichernde Schicht (3b) des zweiten Speicherelements (Tb) eine zweite elektrisch leitende Halbleiterschicht aufweist.

7. Informationsredundante nichtflüchtige Halbleiterspeicherzelle nach einem der Patentansprüche 1 bis 6,
**dadurch gekennzeichnet, dass** die zweite Isolierschicht (4) eine ONO-Schichtenfolge aufweist.

8. Informationsredundante nichtflüchtige Halbleiterspeicherzelle nach einem der Patentansprüche 1 bis 7,
**dadurch gekennzeichnet, dass** die Steuerschicht (5a, 5b) ein elektrisch leitendes Halbleitermaterial und/oder ein metallisches Material aufweist.

9. Informationsredundante nichtflüchtige Halbleiterspeicherzelle nach einem der Patentansprüche 1 bis 8,
**dadurch gekennzeichnet, dass** die erste und/oder zweite Isolierschicht für das erste und zweite Speicherelement (Ta, Tb) unterschiedliche Isolierschichten (2a, 2b, 4a, 4b) aufweisen.

10. Informationsredundante nichtflüchtige Halbleiterspeicherzelle nach einem der Patentansprüche 1 bis 9,
**dadurch gekennzeichnet, dass** die nichtflüchtigen Speicherelemente (Ta, Tb) FLASH-Eintransistorzellen darstellen.

11. Verfahren zur Herstellung einer informationsredundanten nichtflüchtigen Halbleiterspeicherzelle mit den Schritten:
a) Ausbilden von aktiven Bereichen (AA) in einem Halbleitersubstrat (1);
b) Ausbilden einer ersten Isolierschicht (2);
c) Ausbilden und Strukturieren einer ladungsspeichernden Schicht (3a) für ein erstes Speicherelement (Ta);
d) Ausbilden einer Tunnel-Isolierschicht (2') zumindest an einem Teilbereich der strukturierten ladungsspeichernden Schicht (3a);
e) Ausbilden und Strukturieren einer ladungsspeichernden Schicht (3b) für ein zweites Speicherelement (Tb) derart, dass ein Ladungsaustausch zwischen den ladungsspeichernden Schichten (3a, 3b) über die Tunnel-Isolierschicht (2') ermöglicht ist;
f) Ausbilden einer zweiten Isolierschicht (4);
g) Ausbilden und Strukturieren einer jeweiligen Steuerschicht (5a, 5b) zur Realisierung von Wortleitungen (WLa, WLb) für das erste und zweite Speicherelement (Ta, Tb);
h) weiteres Strukturieren der ersten und zweiten Isolierschicht (2, 4) sowie der ersten und zweiten ladungsspeichernden Schicht (3a, 3b) zum Ausbilden von isolierten ladungsspeichernden Inseln;
i) Ausbilden von jeweiligen Source-/Draingebieten (S/D) für das erste und zweite Speicherelement (Ta, Tb) in jeweiligen aktiven Bereichen (AA);
j) Ausbilden einer dritten Isolierschicht (6) mit Kontaktlöchern zu den jeweiligen Source-/Draingebieten (S/D);
k) Ausbilden von Kontakten (K) in den Kontaktlöchern; und
l) Ausbilden und Strukturieren einer Bitleitungsschicht (7) zur Realisierung von ersten und zweiten Bitleitungen (BLSa, BLDa, BLSb, BLDb) für das erste und zweite Speicherelement (Ta, Tb).

12. Verfahren nach Patentanspruch 11,
**dadurch gekennzeichnet, dass** in Schritt b) eine OTP-Schicht zum einmaligen Programmieren der nichtflüchtigen Speicherelemente (Ta, Tb) als erste Isolierschicht (2) ausgebildet wird.

13. Verfahren nach Patentanspruch 11 oder 12,
**dadurch gekennzeichnet, dass** in Schritt c) und e) eine elektrisch leitende Schicht als ladungsspeichernde Schicht (3a, 3b) ausgebildet wird.

14. Verfahren nach einem der Patentansprüche 11 bis 13,
**dadurch gekennzeichnet, dass** in Schritt d) eine Tunneloxidschicht als Tunnel-Isolierschicht (2') thermisch ausgebildet wird.

15. Verfahren nach einem der Patentansprüche 11 bis 14,
**dadurch gekennzeichnet, dass** in Schritt f) eine ONO-Schichtenfolge als zweite Isolierschicht (4) ausgebildet wird.

16. Verfahren nach einem der Patentansprüche 11 bis 15,
**dadurch gekennzeichnet, dass** in Schritt i) die Source-/Draingebiete (S/D) unter Verwendung der strukturierten Steuerschicht (5a, 5b), der zweiten Isolierschicht (4), der ladungsspeichernden Schicht (3a, 3b) und der ersten Isolierschicht (2) als Maske mittels Ionenimplantation selbstjustierend ausgebildet werden.

17. Verfahren zum Vorladen einer informationsredundanten nichtflüchtigen Halbleiterspeicherzelle nach einem der Patentansprüche 1 bis 10, mit den Schritten:
a) Anlegen einer ersten positiven Vorladespannung an die Steuerschichten (CGa, CGb) der nichtflüchtigen Halbleiterspeicherzelle (SZ); und
b) Anlegen einer zweiten Vorladespannung, die kleiner als die erste Vorladespannung ist, an die Source-/Draingebiete (Sa, Da, Sb, Db) der nichtflüchtigen Speicherelemente (Ta, Tb) derart, dass Ladungsträger mittels Fowler-Nordheim-Tunneln in die ladungsspeichernden Schichten (3a, 3b) eingebracht werden.

18. Verfahren zum Vorladen einer informationsredundanten nichtflüchtigen Halbleiterspeicherzelle nach einem der Patentansprüche 1 bis 10, mit den Schritten:
a) Anlegen einer ersten positiven Vorladespannung an die Steuerschichten (CGa, CGb) der nichtflüchtigen Halbleiterspeicherzelle (SZ);
b) Anlegen einer zweiten Vorladespannung, die kleiner als die erste Vorladespannung ist, an die Sourcegebiete (Sa, Sb); und
c) Anlegen einer dritten Vorladespannung, die kleiner als die erste Vorladespannung aber größer als die zweite Vorladespannung ist, an die Draingebiete (Da, Db) der nichtflüchtigen Speicherelemente (Ta, Tb) derart, dass Ladungsträger mittels Kanalinjektion in die ladungsspeichernden Schichten (3a, 3b) eingebracht werden.

19. Verfahren zum Beschreiben/Löschen von informationsredundanten nichtflüchtigen Halbleiterspeicherzellen (SZ) nach einem der Patentansprüche 1 bis 10, mit den Schritten:
a) Anlegen einer ersten positiven Schreibspannung an die Steuerschicht (CGa) des ersten Speicherelements (Ta);
b) Anlegen einer zweiten negativen Schreibspannung an die Steuerschicht (CGb) des zweiten Speicherelements (Tb);
c) Anlegen einer dritten Schreibspannung, die kleiner als die erste Schreibspannung ist, an die Source-/Draingebiete (Sa, Da) des ersten Speicherelements (Ta); und
d) Anlegen einer vierten Schreibspannung, die kleiner als die dritte Schreibspannung aber größer als die zweite Schreibspannung ist, an die Source-/Draingebiete (Sb, Db) des zweiten Speicherelements (Tb).

20. Verfahren zum Lesen von informationsredundanten nichtflüchtigen Halbleiterspeicherzellen (SZ) nach einem der Patentansprüche 1 bis 10, mit den Schritten:
a) Anlegen einer ersten negativen Lesespannung an die Steuerschichten (CGa, CGb) der Speicherelemente (Ta, Tb) zum Auswählen einer nichtflüchtigen Halbleiterspeicherzelle;
b) Anlegen einer zweiten Lesespannung, die größer als die erste Lesespannung ist, an die Sourcegebiete (Sa, Sb) des ersten und zweiten Speicherelements (Ta, Tb) der ausgewählten Halbleiterspeicherzelle (SZ);
c) Anlegen einer dritten Lesespannung, die größer als die zweite Lesespannung ist, an die Draingebiete (Da, Db) des ersten und zweiten Speicherelements (Ta, Tb) der ausgewählten Halbleiterspeicherzelle (SZ); und
d) Vergleichen der Kanalströme (Ia, Ib) des ersten und zweiten Speicherelements (Ta, Tb), wobei ein Informationsgehalt "1" ist, wenn der Kanalstrom (Ia) des ersten Speicherelements (Ta) größer als der Kanalstrom (Ib) des zweiten Speicherelements (Tb) ist.

21. Verfahren nach Patentanspruch 20, mit dem weiteren Schritt:
Anlegen einer positiven Passivierungsspannung an die Steuerschichten (CGa, CGb) der Speicherelemente (Ta, Tb) von nicht ausgewählten Halbleiterspeicherzellen (SZ).

## Claims

1. Information-redundant non-volatile semiconductor memory cell comprising
a first and a second non-volatile memory element (Ta, Tb), which each have a layer sequence composed of a first insulating layer (2), a charge-storing layer (3a, 3b), a second insulating layer (4a, 4b) and a control layer (5a, 5b) on a respective active area (AA) of a semiconductor substrate (1) and each have source/drain regions (S/D), wherein the charge-storing layers (3a, 3b) are coupled to one another by means of a tunnel insulating layer (2') in such a way that charge exchange between the memory elements (Ta, Tb) is made possible.

2. Information-redundant non-volatile semiconductor memory cell according to Patent Claim 1,
**characterized in that** the tunnel insulating layer (2') comprises a tunnel oxide.

3. Information-redundant non-volatile semiconductor memory cell according to Patent Claim 1 or 2,
**characterized in that** the tunnel insulating layer (2') is formed substantially perpendicularly to the substrate surface between the charge-storing layers (3a, 3b).

4. Information-redundant non-volatile semiconductor memory cell according to any of Patent Claims 1 to 3,
**characterized in that** the tunnel insulating layer (2') is formed substantially parallel to the substrate surface between the charge-storing layers (3a, 3b).

5. Information-redundant non-volatile semiconductor memory cell according to any of Patent Claims 1 to 4,
**characterized in that** the first insulating layer (2) has an OTP layer for the one-time programming of the non-volatile memory elements (Ta, Tb).

6. Information-redundant non-volatile semiconductor memory cell according to any of Patent Claims 1 to 5,
**characterized in that** the charge-storing layer (3a) of the first memory element (Ta) has a first electrically conductive semiconductor layer and the charge-storing layer (3b) of the second memory element (Tb) has a second electrically conductive semiconductor layer.

7. Information-redundant non-volatile semiconductor memory cell according to any of Patent Claims 1 to 6,
**characterized in that** the second insulating layer (4) has an ONO layer sequence.

8. Information-redundant non-volatile semiconductor memory cell according to any of Patent Claims 1 to 7,
**characterized in that** the control layer (5a, 5b) comprises an electrically conductive semiconductor material and/or a metallic material.

9. Information-redundant non-volatile semiconductor memory cell according to any of Patent Claims 1 to 8,
**characterized in that** the first and/or second insulating layer for the first and second memory elements (Ta, Tb) have/has different insulating layers (2a, 2b, 4a, 4b).

10. Information-redundant non-volatile semiconductor memory cell according to any of Patent Claims 1 to 9,
**characterized in that** the non-volatile memory elements (Ta, Tb) constitute FLASH one-transistor cells.

11. Method for fabricating an information-redundant non-volatile semiconductor memory cell comprising the following steps:
a) forming active areas (AA) in a semiconductor substrate (1);
b) forming a first insulating layer (2);
c) forming and patterning a charge-storing layer (3a) for a first memory element (Ta);
d) forming a tunnel insulating layer (2') at least at a partial area of the patterned charge-storing layer (3a);
e) forming and patterning a charge-storing layer (3b) for a second memory element (Tb) in such a way that charge exchange between the charge-storing layers (3a, 3b) is made possible via the tunnel insulating layer (2');
f) forming a second insulating layer (4);
g) forming and patterning a respective control layer (5a, 5b) for realizing word lines (WLa, WLb) for the first and second memory elements (Ta, Tb);
h) patterning further the first and second insulating layers (2, 4) and also the first and second charge-storing layers (3a, 3b) in order to form insulated charge-storing islands;
i) forming respective source/drain regions (S/D) for the first and second memory elements (Ta, Tb) in respective active areas (AA);
j) forming a third insulating layer (6) with contact holes to the respective source/drain regions (S/D);
k) forming contacts (K) in the contact holes; and
l) forming and patterning a bit line layer (7) for realizing first and second bit lines (BLSa, BLDa, BLSb, BLDb) for the first and second memory elements (Ta, Tb).

12. Method according to Patent Claim 11,
**characterized in that** in step b) an OTP layer for the one-time programming of the non-volatile memory elements (Ta, Tb) is formed as the first insulating layer (2).

13. Method according to Patent Claim 11 or 12,
**characterized in that** in steps c) and e) an electrically conductive layer is formed as the charge-storing layer (3a, 3b).

14. Method according to any of Patent Claims 11 to 13,
**characterized in that** in step d) a tunnel oxide layer is formed thermally as the tunnel insulating layer (2').

15. Method according to any of Patent Claims 11 to 14,
**characterized in that** in step f) an ONO layer sequence is formed as the second insulating layer (4).

16. Method according to any of Patent Claims 11 to 15,
**characterized in that** in step i) the source/drain regions (S/D) are formed in a self-aligning manner using the patterned control layer (5a, 5b), the second insulating layer (4), the charge-storing layer (3a, 3b) and the first insulating layer (2) as a mask by means of ion implantation.

17. Method for precharging an information-redundant non-volatile semiconductor memory cell according to any of Patent Claims 1 to 10, comprising the following steps:
a) applying a first positive precharge voltage to the control layers (CGa, CGb) of the non-volatile semiconductor memory cell (SZ); and
b) applying a second precharge voltage, which is less than the first precharge voltage, to the source/drain regions (Sa, Da, Sb, Db) of the non-volatile memory elements (Ta, Tb) in such a way that charge carriers are introduced into the charge-storing layers (3a, 3b) by means of Fowler-Nordheim tunnelling.

18. Method for precharging an information-redundant non-volatile semiconductor memory cell according to any of Patent Claims 1 to 10, comprising the following steps:
a) applying a first positive precharge voltage to the control layers (CGa, CGb) of the non-volatile semiconductor memory cell (SZ);
b) applying a second precharge voltage, which is less than the first precharge voltage, to the source regions (Sa, Sb); and
c) applying a third precharge voltage, which is less than the first precharge voltage but greater than the second precharge voltage, to the drain regions (Da, Db) of the non-volatile memory elements (Ta, Tb) in such a way that charge carriers are introduced into the charge-storing layers (3a, 3b) by means of channel injection.

19. Method for writing to/erasing information-redundant non-volatile semiconductor memory cells according to any of Patent Claims 1 to 10, comprising the following steps:
a) applying a first positive write voltage to the control layer (CGa) of the first memory element (Ta);
b) applying a second negative write voltage to the control layer (CGb) of the second memory element (Tb);
c) applying a third write voltage, which is less than the first write voltage, to the source/drain regions (Sa, Da) of the first memory element (Ta); and
d) applying a fourth write voltage, which is less than the third write voltage but greater than the second write voltage, to the source/drain regions (Sb, Db) of the second memory element (Tb).

20. Method for reading information-redundant non-volatile semiconductor memory cells (SZ) according to any of Patent Claims 1 to 10, comprising the following steps:
a) applying a first negative read voltage to the control layers (CGa, CGb) of the memory elements (Ta, Tb) in order to select a non-volatile semiconductor memory cell;
b) applying a second read voltage, which is greater than the first read voltage, to the source regions (Sa, Sb) of the first and second memory elements (Ta, Tb) of the selected semiconductor memory cell (SZ);
c) applying a third read voltage, which is greater than the second read voltage, to the drain regions (Da, Db) of the first and second memory elements (Ta, Tb) of the selected semiconductor memory cell (SZ); and
d) comparing the channel currents (Ia, Ib) of the first and second memory elements (Ta, Tb), wherein an information content is "1" if the channel current (Ia) of the first memory element (Ta) is greater than the channel current (Ib) of the second memory element (Tb).

21. Method according to Patent Claim 20, comprising the following further step:
applying a positive passivation voltage to the control layers (CGa, CGb) of the memory elements (Ta, Tb) of non-selected semiconductor memory cells (SZ).

## Revendications

1. Cellule de mémoire à semiconducteur rémanente à information redondante, comprenant
un premier et un deuxième éléments (Ta, Tb) de mémoire rémanente, qui ont respectivement une succession de couches composée d'une première couche (2) isolante, d'une couche (3a, 3b) d'emmagasinage d'une charge, d'une deuxième couche (4a, 4b) isolante et d'une couche (5a, 5b) de commande sur une zone (AA) active respectivement d'un substrat (1) à semiconducteur et respectivement des régions (S/D) de source/drain, les couches (3a, 3b) emmagasinant une charge étant couplées entre elles par une couche (2') isolante tunnel, de manière à rendre possible un échange de charge entre les éléments (Ta, Tb) de mémoire.

2. Cellule de mémoire à semiconducteur rémanente à information redondante, suivant la revendication 1,
**caractérisée en ce que** la couche (2') isolante tunnel comporte un oxyde de tunnel.

3. Cellule de mémoire à semiconducteur rémanente à information redondante, suivant la revendication 1 ou 2,
**caractérisée en ce que** la couche (2') isolante tunnel est formée entre les couches (3a, 3b) emmagasinant une charge en étant sensiblement perpendiculaire à la surface du substrat.

4. Cellule de mémoire à semiconducteur rémanente à information redondante, suivant l'une des revendications 1 à 3,
**caractérisée en ce que** la couche (2') isolante tunnel est formée entre les couches (3a, 3b) emmagasinant une charge en étant sensiblement parallèle à la surface du substrat.

5. Cellule de mémoire à semiconducteur rémanente à information redondante, suivant l'une des revendications 1 à 4,
**caractérisée en ce que** la première couche (2) isolante comporte une couche OTP pour programmer une fois les éléments (Ta, Tb) de mémoire rémanente.

6. Cellule de mémoire à semiconducteur rémanente à information redondante, suivant l'une des revendications 1 à 5,
**caractérisée en ce que** la couche (3) emmagasinant une charge du premier élément (Ta) de mémoire comporte une première couche à semiconducteur conductrice de l'électricité et la couche (3b) emmagasinant une charge du deuxième élément (Tb) de mémoire comporte une deuxième couche à semiconducteur conductrice de l'électricité.

7. Cellule de mémoire à semiconducteur rémanente à information redondante, suivant l'une des revendications 1 à 6,
**caractérisée en ce que** la deuxième couche (4) isolante comporte une succession de couches ONO.

8. Cellule de mémoire à semiconducteur rémanente à information redondante, suivant l'une des revendications 1 à 7,
**caractérisée en ce que** la couche (5a, 5b) de commande comporte un matériau semiconducteur conducteur de l'électricité et/ou un matériau métallique.

9. Cellule de mémoire à semiconducteur rémanente à information redondante, suivant l'une des revendications 1 à 8,
**caractérisée en ce que** la première et/ou la deuxième couche isolante comporte des couches (2a, 2b, 4a, 4b) isolantes différentes pour le premier et deuxième éléments (Ta, Tb) de mémoire.

10. Cellule de mémoire à semiconducteur rémanente à information redondante, suivant l'une des revendications 1 à 9,
**caractérisée en ce que** les éléments (Ta, Tb) de mémoire rémanente constituent des cellules à un transistor FLASH.

11. Procédé de production d'une cellule de mémoire à semiconducteur rémanente à information redondante, comprenant les stades dans lesquels :
a) on forme des zones (AA) actives dans un substrat (1) semiconducteur ;
b) on forme une première couche (2) isolante ;
c) on forme et on structure une couche (3a) emmagasinant une charge pour un premier élément (Ta) de mémoire ;
d) on forme une couche (2') isolante tunnel au moins sur une zone partielle de la couche (3a) structurée emmagasinant une charge ;
e) on forme et on structure une couche (3b) emmagasinant une charge pour un deuxième élément (Tb) de mémoire, de manière à rendre possible un échange de charge entre les couches (3a, 3b) emmagasinant une charge par l'intermédiaire de la couche (2') isolante tunnel ;
f) on forme une deuxième couche (4) isolante ;
g) on forme et on structure une couche (5a, 5b) de commande respective pour la réalisation de lignes (WLa, WLb) de mot pour le premier et le deuxième éléments (Ta, Tb) de mémoire ;
h) on structure davantage la première et la deuxième couches (2, 4) isolantes ainsi que la première et la deuxième couches (3a, 3b) emmagasinant une charge pour former des îlots isolés emmagasinant une charge ;
i) on forme des régions (S/D) de source/drain respectives pour le premier et le deuxième éléments (Ta, Tb) de mémoire dans des zones (AA) actives respectives ;
j) on forme une troisième couche (6) isolante ayant des trous de contact menant aux régions (S/D) de source/drain respectives ;
k) on forme des contacts (K) dans les trous de contact ; et
l) on forme et on structure une couche (7) de lignes de bit pour la réalisation de première et deuxième lignes (BLSa, BLDa, BLSb, BLDb) de bit pour le premier et le deuxième éléments (Ta, Tb) de mémoire.

12. Procédé suivant la revendication 11,
**caractérisé en ce que**, dans le stade b), on forme comme première couche (2) isolante une couche OTP pour programmer une fois les éléments (Ta, Tb) de mémoire rémanente.

13. Procédé suivant la revendication 11 ou 12,
**caractérisé en ce que**, aux stades c) et e), on forme une couche conductrice de l'électricité comme couche (3a, 3b) d'emmagasinage d'une charge.

14. Procédé suivant l'une des revendications 11 à 13,
**caractérisé en ce que**, au stade d), on forme thermiquement une couche d'oxyde tunnel comme couche (2') isolante tunnel.

15. Procédé suivant l'une des revendications 11 à 14,
**caractérisé en ce que**, au stade f), on forme une succession de couches ONO comme deuxième couche (4) isolante.

16. Procédé suivant l'une des revendications 11 à 15,
**caractérisé en ce que**, au stade i), on forme à auto-alignement, au moyen d'une implantation d'ions, les régions (S/D) de source/drain en utilisant la couche (5a, 5b) structurée de commande, la deuxième couche (4) isolante, la couche (3a, 3b) emmagasinant une charge et la première couche (2) isolante comme masque.

17. Procédé de préchargement d'une cellule de mémoire à semiconducteur rémanente à information redondante suivant l'une des revendications 1 à 10, comprenant les stades dans lesquels :
a) on applique une première tension positive de précharge aux couches (CGa, CGb) de commande de la cellule (SZ) de mémoire à semiconducteur rémanente ; et
b) on applique une deuxième tension de précharge, qui est plus basse que la première tension de précharge, aux régions (Sa, Da, Sb, Db) de source/drain des éléments (Ta, Tb) de mémoire rémanente, de manière à introduire des porteurs de charge dans les couches (3a, 3b) emmagasinant une charge au moyen de tunnels Fowler-Nordheim.

18. Procédé de précharge d'une cellule de mémoire à semiconducteur rémanente à information redondante suivant l'une des revendications 1 à 10, comprenant les stades dans lesquels :
a) on applique une première tension positive de précharge aux couches (CGa, CGb) de commande de la cellule (SZ) de mémoire à semiconducteur rémanente ;
b) on applique une deuxième tension de précharge, qui est plus basse que la première tension de précharge, aux régions (Sa, Sb) de source ; et
c) on applique une troisième tension de précharge, qui plus basse que la première tension de précharge, mais plus haute que la deuxième tension de précharge, aux régions (Da, Db) de drain des éléments (Ta, Tb) de mémoire rémanente, de manière à introduire des porteurs de charge dans les couches (3a, 3b) emmagasinant une charge au moyen d'un injection de canal.

19. Procédé pour écrire/effacer dans des cellules (SZ) de mémoire à semiconducteur rémanente à information redondante suivant l'une des revendications 1 à 10, comprenant les stades dans lesquels :
a) on applique une première tension positive d'écriture à la couche (CGa) de commande du premier élément (Ta) de mémoire ;
b) on applique une deuxième tension négative d'écriture à la couche (CGb) de commande du deuxième élément (Tb) de mémoire ;
c) on applique une troisième tension d'écriture, qui est plus basse que la première tension d'écriture, aux régions (Sa, Da) de source/drain du premier élément (Ta) de mémoire ; et
d) on applique une quatrième tension d'écriture, qui est plus basse que la troisième tension d'écriture, mais qui est plus haute que la deuxième tension d'écriture, aux régions (Sb, Db) de source/drain du deuxième élément (Tb) de mémoire.

20. Procédé de lecture de cellules (SZ) de mémoire à semiconducteur rémanente à information redondante suivant l'une des revendications 1 à 10, comprenant les stades dans lesquels :
a) on applique une première tension négative de lecture aux couches (CGa, CGb) de commande des éléments (Ta, Tb) de mémoire pour sélectionner une cellule de mémoire à semiconducteur rémanente ;
b) on applique une deuxième tension de lecture, qui est plus haute que la première tension de lecture, aux régions (Sa, Sb) de source du premier et du deuxième éléments (Ta, Tb) de mémoire de la cellule (SZ) à semiconducteur sélectionnée ;
c) on applique une troisième tension de lecture, qui est plus haute que la deuxième tension de lecture, aux régions (Da, Db) de drain du premier et du deuxième éléments (Ta, Tb) de mémoire de la cellule (SZ) de mémoire à semiconducteur sélectionnée ; et
d) on compare les courants (Ia, Ib) de canal du premier et du deuxième éléments (Ta, Tb) de mémoire, en ayant un contenu informatif "1", lorsque le courant (Ia) de canal du premier élément (Ta) de mémoire est plus grand que le courant (Ib) de canal du deuxième élément (Tb) de mémoire.

21. procédé suivant la revendication 20, comprenant le stade supplémentaire dans lequel :
on applique une tension positive de passivation aux couches (CGa, CGb) de commande des éléments (Ta, Tb) de mémoire des cellules (SZ) de mémoire à semiconducteur, qui ne sont pas sélectionnées.
